# EUROPEAN PATENT APPLICATION

(11) **EP 4 654 192 A1**
(43) Date of publication of application: **26.11.2025**
(21) Application number: 24177840.6
(22) Date of filing: 24.05.2024
(51) Int. Cl.: G11C 7/14, G11C 16/04, G11C 16/28

(54) **A NON-VOLATILE MEMORY, COMPRISING AN IMPROVED GENERATION OF A REFERENCE CURRENT**

(71) Applicant: EM Microelectronic-Marin SA, 2074 Marin (CH)
(72) Inventor: PLAVEC, Lubomir, 61200 Brno (CZ); KHOURI, Osama, 2000 Neuchâtel (CH); KUBAR, Miloslav, 25230 Revnice (CZ)
(74) Representative: ICB SA

(57) **Abstract**

A non-volatile memory comprises, besides the memory cells, dummy reference cells (2) for producing a reference current that enables to discriminate the contents of the memory cells and determine their logic states "0" or "1". According to the invention, the conventional reference cells programmed at a definitive (conductive or non-conductive) state are replaced by cells that are not programmed but are switchable between a plurality of states when trigger signals are applied. Since the reference cells may closely mimic the physical characteristics of the memory cells, they are likely to have similar behaviours, enabling to produce a reliable reference current irrespective of variations of temperature or supply voltage. The association of the reference cells (2) in arrays of parallel branches (23, 29), and individual adjustment devices (30, 31), reduce the effects of random manufacture variations on the cells (2) and reinforce their behaviour similarity with the memory cells.

## Description

### Field of the invention

This invention relates to a non-volatile memory, comprising an improved generation of a reference current used for accurately reading the logic states of the memory cells. It also relates to electronic devices in which such a memory is present.

### Technological background

In non-volatile memories like EEPROM, Flash or the like, bits of information remain stored in programmable memory cells, typically at logic states "1" when a cell is conductive and "0" when it is non-conductive. To determine if a memory cell is conductive or not, the intensity of a current outputted by the memory cell must be compared with a reference current. If this intensity is greater than the reference current, the cell is considered to be at the "1" state. If it is smaller than the reference current, its "0" state is conversely read. The comparisons and decisions may be done by circuits called sense amplifiers.

The reference current is usually provided by dummy cells which are reference cells programmed beforehand. Some of them are conventionally written to the "1" state, and the others erased to the "0" state. A generator of reference current senses the intensities of currents issued by the dummy cells of both groups and calculates the intensity of the reference current. This intensity of the reference current is often the average between the currents issued by the dummies at the "1" state and the currents issued by the dummies at the "0" state. A corresponding device comprising programmed reference cells is exposed in US-A-2019/115061.

Nevertheless, the accuracy of the comparisons by the sense amplifiers is impaired by a group of factors, so that false readings cannot be excluded. Firstly, the increasing miniaturisation of microelectronic components entails greater relative uncertainties of, for instance, the real dimensions of the memory and reference cells. The voltages supplied to the cells, as well as the operating temperatures, are also submitted to variations and perturbations. Thus, the intensities of currents outputted by the memory cells, and the intensity of the reference current, may significantly depart from theoretical values.

A main purpose of the invention consists in reducing these risks of false readings of the logic state of memory cells, due to random variations and perturbations created during the manufacturing of the memory or present during its service.

Another purpose of the invention is to do without a preliminary initialisation of dummies or reference cells in the logic state "0" or "1" during the manufacturing of the memory, which imposes additional hardware and test time.

Another purpose of the invention is to propose a set of reference cells that can more reliably be maintained at the correct logic state throughout the life of the memory.

Still another purpose of the invention consists in simplifying the design and manufacture of non-volatile memories.

Still another purpose is to increase the supply voltage range at which the memory is operative, especially for low supply voltages.

Still another purpose is to adjust the intensity of the reference current at an optimal value with ease.

### Summary of the invention

According to a general definition, the invention concerns a non-volatile memory, comprising:
- memory cells each comprising a select device and a memory device, the select device and the memory device being arranged in series on an electric line of memory cell for outputting an electric current of memory cell indicative of a logic state of the memory cell, wherein the logic state is stored in the memory device, and the select device enables to open and close the line of memory cell;
- at least an array of reference cells arranged on an electric line of reference cell for connecting to a generator of reference current which provides a reference current with currents outputted by the reference cells according to respective states of the reference cells, the reference current being used for reading the logic states of the memory cells;
- characterised in that the reference cells are of a non-programmed type switchable between a plurality of said states of the reference cells.

Thus, the conventional programmable reference cells remaining at the "0" or "1" logic state are replaced by non-programmable reference cells. This involves different advantages. Firstly, as there is no need to write the reference cells at a permanent logic state which must be maintained during the entire life of the memory, the fabrication of the memory is made easier, and the durability may be improved. Secondly, as the reference cells may have designs and structures (as far as dimensions, materials and numbers of components are concerned) similar to the memory cells, a high degree of standardisation of the memory and reference cells may be obtained, and a further simplification of the fabrication. Thirdly, similar memory and reference cells are likely to behave a similar way against variations of voltage or temperature, so that deviations of intensities of the currents to be compared should be similar. The risks of errors in the voltage comparisons are therefore reduced.

The memory cells are advantageously programmable memory cells, for example for EEPROM. The memory cells may have different structures and the reference cells may have different structures, though the structure of the reference cells is close to the one of the memory cells. All memory cells are preferably structurally identical with each other.

Further, the layout of the reference cells in arrays comprising a plurality of reference cells enables to compensate the random variations of their dimensions or other physical parameters, and to minimise the adverse effects of these variations on the accuracy of the reference current. In this respect, it is advantageous that the reference cells in the array are structurally identical with each other, each contributing to the value of the reference current. Optimal arrays could comprise between 10 and 30 of the reference cells. The reference cells are also known as "dummy cells".

This advantage on the accuracy of the reference current is readily obtained if the reference cells of the at least an array are arranged in parallel on respective branches of the line of reference cell: the individual currents outputted by the reference cells will automatically be added on the line of reference cells before reaching the generator of reference current, which need not combine these individual currents itself.

The characteristics of the reference current can also be improved if the line of reference cell is equipped with adjustment resistors, or programmable circuit breakers, or both.

When the line of reference cell is divided into branches each comprising one of the reference cells, the resistors, as well as the circuit breakers, may be present in each of the branches, and/or respective groups of the branches.

The memory cells are preferably in at least an array. Standardisation of the non-volatile memory is especially improved if the at least an array of reference cells has the reference cells arranged with a same spatial layout, a same number of the cells and a same number of lines and/or columns, as the memory cells in at least an array of the memory cells.

The non-programmed reference cells may comprise a conductive state and a non-conductive state, corresponding to "1" and "0" logic states, between them they are switchable.

In preferred embodiments of the invention, such reference cells are manufactured with a design resembling the memory cells as far as possible. They may therefore comprise a first select device and a second select device which are arranged in series on the line of reference cell, the first select device and the second select device both enabling to open and close the line of reference cell.

In this definition, the reference cells and the memory cells all comprise two main components, which are rather similar; especially, all the cells comprise a select device which may be the same. Thus, a degree of standardisation of all the cells is already obtained, with the advantages summarised above of an easier fabrication, similar sensitivities to process, temperature and voltage perturbations, therefore a diminished risk of reading errors.

In a preferred embodiment, the select devices of the memory cells, the first select devices, the second select devices and the memory devices are all transistors having drains and sources embedded in a substrate, and gates arranged in layers deposited on said substrate.

In this arrangement, the memory cells and reference cells may be easily manufactured in a process made of few steps, together and on a common substrate.

The similarities between the memory cells and reference cells can advantageously be exploited to the point that the select devices of the memory cells and the first select devices have similar dimensions, materials and operations, the memory devices and the second select devices have similar dimensions, and the substrate is common to the memory cells and the reference cells. An excellent match of the behaviours of the reference and memory cells when they undergo the perturbations is ensured.

The design simplification is apparent in a preferred embodiment, according to which the select devices of the memory cells, the first select devices and the second select devices have control gates present in a first of said layers, closer to the substrate, and the memory devices have floating gates present in a second of said layers, separated from the substrate by said first layer. When the substrate has been prepared, only two layers are essential for completing the manufacture of all the components of both the memory cells and reference cells.

Another aspect of the invention is an electronic device, comprising a non-volatile memory as above, a generator of reference current and sense amplifiers for reading the logic states of the memory cells, which are connected to the lines of memory cell and to an output of the generator of reference current, on which the reference current is present.

An array composed of a plurality of sense amplifiers is often present in electronic devices comprising a non-volatile memory so that several memory cells can be read simultaneously. The invention allows to perform the logic state determinations with a single generator of reference current if said output of the generator of reference current consists in a branched electric line, the intensity of the reference current being divided between branches of said branched electric line respectively leading to the sense amplifiers.

Advantageously, all the reference cells in the array are controlled in unison by a unitary branched circuit.

### Short description of the figures

These characteristics, purposes and advantages of the invention will now be exposed more in detail with the help of the following figures, which completely disclose preferred embodiments of the invention, in a purely illustrative way only:
- Figure 1: a schematic representation of an electronic device;
- Figure 2: a cross-section of a memory cell;
- Figure 3: a cross-section of a reference cell according to a particular embodiment of the invention;
- Figure 4: an array of the reference cells, in an embodiment of the invention;
- Figure 5: a possible dispatch of the reference current to a plurality of sense amplifiers;
- Figure 6: an array of the reference cells, in another embodiment of the invention;
- Figure 7: a diagram showing the behaviours of memory and reference cells;
- Figure 8: a diagram showing the intensity adjustment of the reference current.

### Detailed description of the invention

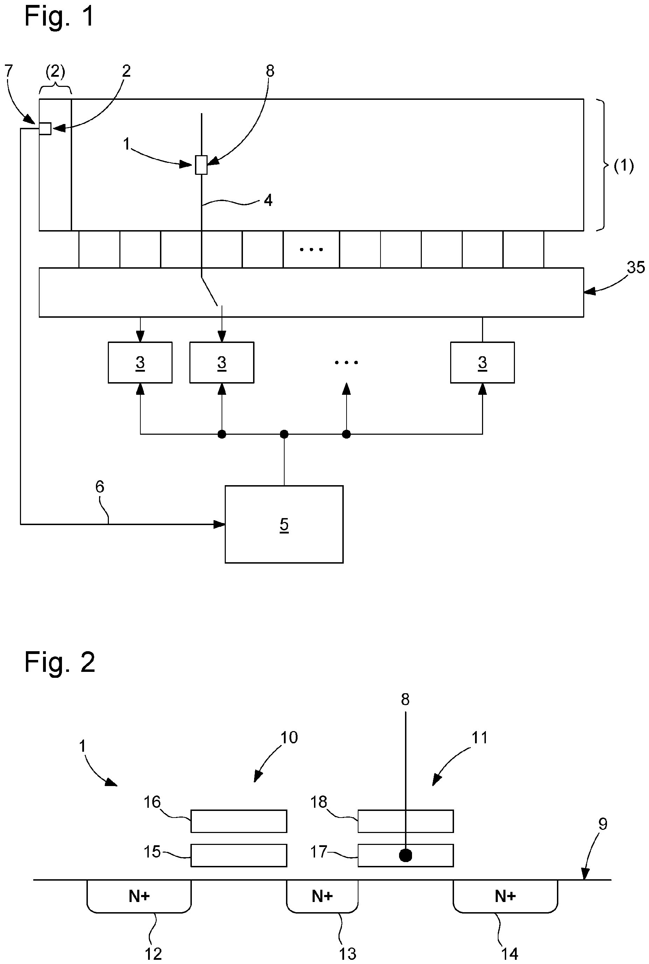

Figure 1 shows a schematic representation of an electronic device according to the invention. It comprises arrays of cells including programmable memory cells 1 and dummy cells which are called reference cells 2. The arrays of memory cells 1 are connected to a first input of one or several sense amplifiers 3 by electric lines of memory cell 4 through a multiplexer 35, and each array of the dummy reference cells 2 is connected to an input of a generator of reference current 5 by an electric line of reference cell 6. The generator of reference current 5 combines the individual currents outputted by the reference cells 2 and calculates a reference current which it communicates to a second input of the sense amplifiers 3, when the relevant reference cells 2 are switched on by a trigger signal 7. Further, other trigger signals 8 selectively switch the memory cells 1 on for reading them. When one of the memory cells 1 on a particular line of memory cells 4 in switched on, the relevant sense amplifier 3 compares the intensity Iref of the reference current with the intensity of a current flowing in the particular line of memory cell 4. When the latter is higher than the reference current, the memory cell 1 which has been switched on is found conductive and is read as having been programmed at a logic state "1", otherwise it is found as non-conductive and its programmed logic state is read as "0".

A more detailed embodiment of the non-volatile memory, in which all the cells pertain to the EEPROM type, will be described now. The invention could nevertheless be implemented with any other suitable type of cells available in the art.

One of the programmable memory cells 1 is disclosed in Figure 2, the others being similar, and all the memory cells 1 and the non-programmable reference cells 2 being arranged on a common substrate 9. The memory cells 1 consist of a pair of transistors arranged in series along the relevant line of memory cell 4. One of the transistors is a memory device 10, and the second is a select device 11. Three conductive channels 12, 13 and 14 (N⁺ if the transistors are of the NPN technology) are created in succession in the substrate 9 and form the sources and drains of the transistors, the memory device 10 linking channels 12 and 13 and the select device 11 linking channels 13 and 14.

Further, the memory device 10 comprises a bottom layer 15 deposited on the substrate 9, an upper layer 16 deposited on the bottom layer 15, and the select device 11 also comprises a bottom layer 17 deposited on the substrate 9 and an upper layer 18 deposited on the bottom layer 17. All these layers are in polysilicon.

The memory device 10 determines the logic state of the memory cells 1, according to the electric state of the upper layer 16 which contains a floating gate so that the memory device 10 can become conductive or non-conductive. The select device 11 has its gate in the bottom layer 17, and this gate receives the trigger signals 8. When a trigger signal 8 arrives at the select device 11, the memory cell 1 becomes conductive if the floating gate in the upper layer 16 of the memory device 10 is programmed at the "1" logic state, but remains non-conductive if the floating gate is programmed at the "0" logic state.

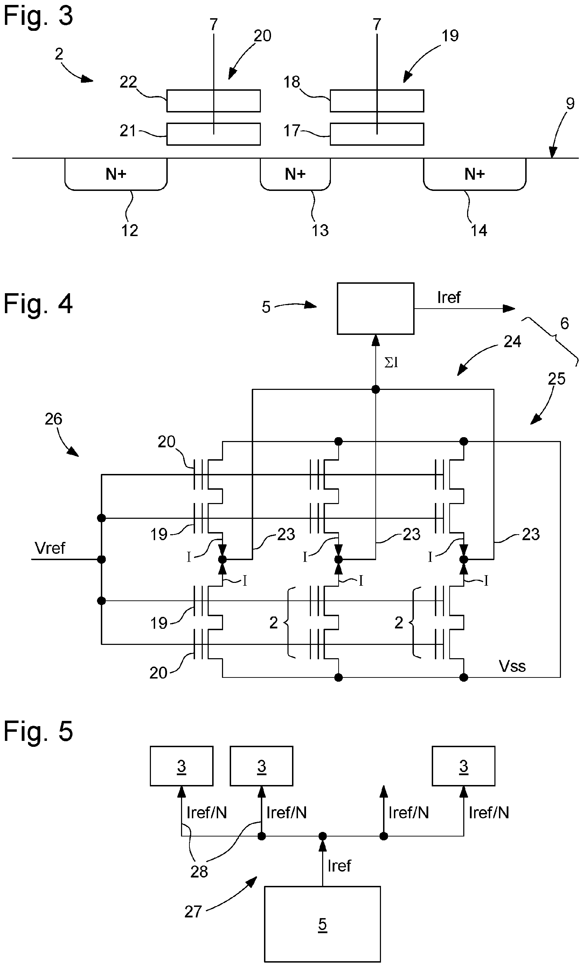

Comparison is now made with one of the reference cells 2 according to the invention and a possible embodiment of which is illustrated in Figure 3. The reference cells 2 also consist of a pair of transistors. A part of the description of the memory cells 1 applies to them so that similar numerals with the prime symbol (`) will be used. However, while one of the transistors is a first select device 19 very similar to the select device 11 of the memory cells 1, the other transistor is a second select device 20 which has design and properties similar to the first select device 19.

The first select device 19 and the second select device 20 are therefore arranged in series on the substrate 9 which again comprises three aligned conductive channels 12', 13' and 14', the first select device 19 linking channels 13' and 14', and the second select device 20 linking channels 12' and 13'. The first select device 19 is manufactured with a bottom layer 17' and an upper layer 18', and the bottom layer 17' contains the gate of the transistor; whereas the second select device 20 is manufactured with a bottom layer 21 and an upper layer 22 and, like the first select device 19; but in contrast with the memory device 10, the gate of the second select device 20 is a non-floating gate present in the bottom layer 21, and no floating gate is present. The trigger signal 7 must be applied to the gates of both the first select device 19 and the second select device 20, thus to the bottom layers 17' and 21, to render the reference cells 2 conductive and able to deliver the reference current. Thus, the dummy reference cells 2 lack any floating gate, and more generally any programmable component. Their conductive or non-conductive state only depends on the presence or absence of a trigger signal 7.

The advantages of this design can be summarised as follows. Although the redundant arrangement of the reference cells 2 with two successive transistors seems cumbersome, it enables a much simpler manufacture of the non-volatile memory since the memory cells 1 and dummy reference cells 2 have almost the same structure and the same dimensions so that a more regular layout of the cells becomes possible. Further, since all the transistors comprise the same number of layers, the manufacture process is straightforward, the non-floating gates being all created when a first polysilicon layer has been deposited, and the floating gates of the memory devices 10 being created when a second polysilicon layer has been deposited. A lesser dispersion of the cell characteristics (area, thickness, etc.) is expected, with a lesser dispersion of the current intensities they deliver.

Moreover, the similarities between the cells and between their transistors diminish the overall sensitivity of the non-volatile memory to fluctuations of supplied voltage and temperature, because all the cells are likely to be affected at a same degree. Thus, it is expected that the intensity of the reference current will remain near the average of the currents delivered by the memory cells 1 at the conductive and non-conductive state in all circumstances.

All these advantages will result in a much lesser risk of false readings of the memory cells 1.

Nevertheless, it would be possible to depart from an almost perfect similarity between the memory cells 1 and dummy reference cells 2: the upper layer (18' and 22) of the reference cells 2 could for instance be omitted; or one of the select devices 19 and 20 could be replaced by a resistor. Finally, the programmable memory cells 1 need not be identical with each other: on the contrary, different structures or technologies may coexist for them on the common substrate 9. The same remark applies for the non-programmable reference cells 2.

Other aspects of the invention will now be described.

The dispersion of the reference current from the theoretical value can be contained if an array of reference cells like in Figure 4 is preferred. This array comprises a plurality of the reference cells 2. The line of reference cell 6 associated to the array has a bifurcated downstream part 24 which divides from the generator of reference current 5 into branches 23 respectively leading to the drains of the reference cells 2 (i.e. the drains of the downstream transistor, which is the first select device 19 in the embodiment of Figure 3). The intensity ΣI of the current supplied to the generator of reference current 5 by the array is the sum of the individual currents I (which may be slightly different) outputted by the reference cells 2. The generator of reference current 5 calculates the intensity Iref of the reference current (for instance by averaging the intensities it receives when all the reference cells are conductive, then non-conductive), and it transmits the reference current to the sense amplifiers 3. Finally, the sense amplifiers 3 perform the comparisons with the currents from the memory cells 1. The non-volatile memory may comprise a plurality of such arrays.

The opposite, upstream part 25 of the line of reference cell 6 is arranged as a bus line elevating the sources of all the reference cells 2 (the sources of the second select devices 20 in this embodiment) to a common supply voltage Vss. The trigger signals 7 are transmitted to the gates of the first and second select devices 19 and 20 through another bifurcated line which belongs to a branched control circuit 26. Since the reference cells 2 become conductive only when both the first and second select devices 19 and 20 are so simultaneously, a unitary device for producing the trigger signals 7 is preferred. The provision of several reference cells 2 for producing a common output signal tends to lower the effects of random variations in their dimensions, etc. While Figure 4 shows eight reference cells 2, a number of 10 to 30 in each array is appreciated for optimal results.

The supply voltage of the trigger signals 7 may be equal to the above-mentioned supply voltage Vss, to the trigger signals 8 to the memory cells 1, or not.

An optional but valuable feature of the invention consists in that the array or arrays of the reference cells 2, like the array in Figure 4, are similar to arrays of the memory cells 1 as regards the numbers, spatial spacings and layouts of the cells in the arrays, and the numbers of lines and columns of the cells in the arrays. The non-volatile memory may display a perfectly regular arrangement of all the memory and reference cells 1 and 2 over its surface, involving an easier fabrication and prospects of reduced dispersions in the physical parameters characterising the cells and their operation.

Further optional features of this invention will now be disclosed. Figure 5 illustrates that the reference current may be transmitted to a plurality of the sense amplifiers 3 simultaneously, by flowing on a branched line 27. Each of the branches 28 connects to a respective sense amplifier 3 and supplies it a fraction of the intensity Iref of the reference current (Iref/N if there are "N" branches 28 having the same conductivity). The arrangement with a plurality of sense amplifiers 3 is valuable in allowing as many of the memory cells 1 to be read simultaneously through a plurality of distinct lines of memory cell 4.

A scaling of the intensities supplied by the generator of reference current 5 is performed by the sense amplifiers 3 when it is necessary for a proper comparison with the intensities of the currents generated in the lines of memory cell 4.

Alternatively, the current provided by the generator of reference current 5 could arrive at the sense amplifiers 3 indirectly, after having been mirrored in mirror circuits.

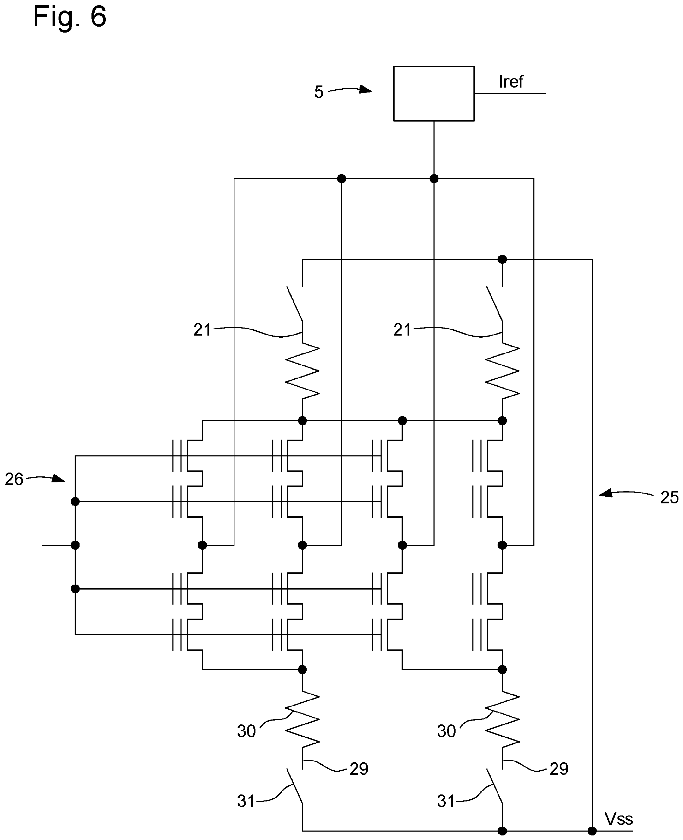

Important improvements are disclosed in Figure 6. The line of reference cell 6 is provided with resistors 30 and circuit breakers 31. In this embodiment, one of the resistors 30 and one of the circuit breakers are present in series in each of grouping branches 29 of the upstream part 25, and each of the grouping branches 29 leads to a group of several (two here) of the dummy reference cells 2. Other arrangements would be possible: either the resistors 30 and circuit breakers 31 could be omitted, they could be provided in different numbers in other parts of the line of reference cell 6, and there could exist one resistor 30 and one circuit breaker associated to each of the reference cells 2, for instance. The following remarks on their interest would still apply.

Despite the interest of manufacturing the reference cells similar to the memory cells, structural differences between them are likely to remain and may render their behaviours somewhat different even if identical trigger signals 7 and 8 are applied. For instance, the second select devices 20 of the reference cells 2 differ from the memory devices 10 of the memory cells 1 because their gates are located in different polysilicon layers. Such structural differences can involve different sensitivities of the currents outputted by the different cells with respect to the voltage supplied to them.

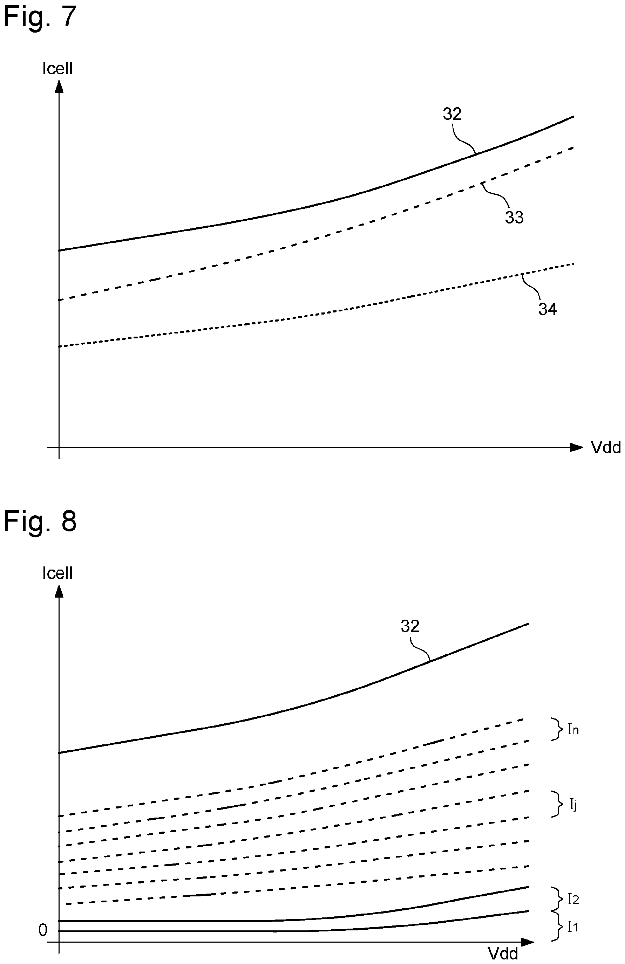

This will be explained with the help of Figure 7. Figure 7 shows that the intensity Icell of current outputted through a typical memory cell 1 in the conductive state is a curve 32 increasing with increasing drain voltages Vdd. The intensity of current outputted through a typical reference cell 2 may be another curve 33, also increasing with increasing drain voltages Vdd, but with a different, steeper slope. It would therefore be difficult to produce a reference current that would be accurate for all values of Vdd. However, the resistors 30 enable to adjust and diminish this greater sensitivity of the reference cells 2 to the drain voltage Vdd and to obtain a modified curve 34 for the reference cells 2, which is at an almost constant ratio with curve 32. A satisfactory reference current can easily be obtained then, whatever the value of voltage Vdd will be.

And the circuit breakers 31 enable to select the reference cells 2 that will contribute to the fabrication of the reference current, only the reference cells 2 associated with closed circuit breakers 31 remaining active. The choice of opening or closing various circuit breakers 31 is made in a preliminary calibration of the non-volatile memory. Two criteria could be adopted: choosing the exact number of the reference cells 2 that will produce a target value of the reference current; or excluding reference cells 2 with an erratic behaviour.

This is how the first criterion can be implemented. If for instance the electronic device comprises a splitting of the reference current like in Figure 5, each of the reference cells 2 will contribute to the reference current with a weak intensity I1, I2,..., In as illustrated in Figure 8, well below the intensity Icell outputted by a memory cell 1. The calibration of the device consists in successively closing the circuit breakers 31 until the sum of these weak currents best matches half the intensity Icell, which may correspond to the sum (I1+I2+...+Ij) here. The remaining circuit breakers 31 will remain open after the calibration.

Other embodiments within the scope of the invention would comprise the resistors 30 only, or the circuit breakers 31 only, of course. More generally, the features separately disclosed here can be combined or not.

### Nomenclature

1. Memory cell
2. Reference cell
3. Sense amplifier
4. Line of memory cell
5. Generator of reference current
6. Line of reference cell
7. Trigger signal
8. Trigger signal
9. Substrate
10. Memory device
11. Select device
12. Channel
13. Channel
14. Channel
15. Bottom layer
16. Upper layer
17, 17'. Bottom layer
18, 18'. Upper layer
19. First select device
20. Second select device
21. Bottom layer
22. Upper layer
23. Branches
24. Downstream part
25. Upstream part
26. Branched control circuit
27. Branched line
28. Branches
29. Grouping branches
30. Resistors
31. Circuit breakers
32, 33, 34. Curves
35. Multiplexer
I. Individual current
ΣI. Sum of the individual currents
I1, I2, ..., Ij, ..., In. Intensities of individual currents
Icell. Intensity of memory cell current
Iref. Intensity of reference current
Iref/N Split reference current
Vdd. Drain voltage
Vss. Supply voltage

## Claims

1. A non-volatile memory, comprising:
- memory cells (1) each comprising a select device (11) and a memory device (10), the select device and the memory device being arranged in series on an electric line of memory cell (4) for outputting an electric current of memory cell indicative of a logic state of the memory cell, wherein the logic state is stored in the memory device (10), and the select device (11) enables to open and close the line of memory cell;
- at least an array of reference cells (2) arranged on an electric line of reference cell (6) for connecting to a generator of reference current (5) which provides a reference current with currents outputted by the reference cells (2) according to respective states of the reference cells, the reference current being used for reading the logic states of the memory cells (1);
- **characterised in that** the reference cells (2) are of a non-programmed type switchable between a plurality of said states of the reference cells.

2. The non-volatile memory according to claim 1, **characterised in that** the array comprises a plurality of the reference cells (2) which are structurally identical with each other, and/or **in that** the memory cells are identical with each other.

3. The non-volatile memory according to claim 1 or 2, **characterised in that** said at least an array comprises between 10 and 30 of the reference cells.

4. The non-volatile memory according to any of claims 1, 2 or 3, **characterised in that** the reference cells (2) of the at least an array are arranged in parallel on respective branches (23) of the line of reference cell (6).

5. The non-volatile memory according to claim 4, **characterised in that** the line of reference cell (6) is equipped with adjustment resistors (30), preferably a plurality of the adjustment resistors (30) which are present in each of the branches (23), and/or respective groups (29) of the branches.

6. The non-volatile memory according to any of claims 4 or 5, **characterised in that** the line of reference cell (6) is equipped with programmable circuit breakers (31) which are present in each of the branches, and/or respective groups (29) of said branches (23).

7. The non-volatile memory according to any of claims 1 to 6, **characterised in that** said at least an array of reference cells (2) has the reference cells (2) arranged with a same spatial layout, a same number of cells and a same number of lines and columns, as the memory cells (1) in at least an array of the memory cells.

8. The non-volatile memory according to any of claims 1 to 7, **characterised in that** the reference cells (2) are switchable between a conductive state and a non-conductive state.

9. The non-volatile memory according to claim 8, **characterised in that** the reference cells (2) each comprise a first select device (19) and a second select device (20) which are arranged in series on the line of reference cell (6), the first select device and the second select device both enabling to open and close the line of reference cell (6).

10. The non-volatile memory according to claim 9, **characterised in that** the select devices (11) of the memory cells (1), the first select devices (19), the second select devices (20) and the memory devices (10) are all transistors having drains and sources embedded in a substrate (9) common to the memory cells (1) and the reference cells (2), and gates arranged in layers (16, 17, 17', 21) deposited on said substrate.

11. The non-volatile memory according to claim 10, **characterised in that** the select devices (11) of the memory cells (1) and the first select devices (19) have similar dimensions, materials and operations, and the memory devices (10) and the second select devices (20) have similar dimensions.

12. The non-volatile memory according to any of claims 10 and 11, **characterised in that** the select devices (11) of the memory cells (1), the first select devices (19) and the second select devices (20) have control gates present in a first of said layers, closer to the substrate (9), and the memory devices (10) have floating gates present in a second of said layers, separated from the substrate by said first layer.

13. An electronic device, comprising the non-volatile memory according to any of the previous claims, the generator of reference current (5) and sense amplifiers (3) for reading the logic states of the memory cells (1), which are connected to the lines of memory cell (4) and to an output of the generator of reference current (5), on which the reference current is present.

14. The electronic device according to claim 13, **characterised in that** said output of the generator of reference current (5) consists in a branched electric line (27), the intensity of the reference current being divided between branches (28) of said branched electric line (27) respectively leading to the sense amplifiers (3).

15. The electronic device according to any of claims 13 or 14, **characterised in that** it comprises a branched circuit (26) for controlling in unison all the reference cells (2) of the array.
